# EUROPÄISCHE PATENTSCHRIFT

(11) **EP 0 500 988 B1**
(45) Veröffentlichungstag und Bekanntmachung des Hinweises auf die Patenterteilung: **22.02.1995**
(21) Anmeldenummer: 91102944.5
(22) Anmeldetag: 27.02.1991
(51) Int. Cl.: H04R 25/02

(54) **Am Kopf zu tragendes Hörgerät**
Hearing aid to be worn on the head
Prothèse auditive à porter à la tête

(43) Veröffentlichungstag der Anmeldung: 02.09.1992
(73) Patentinhaber: Siemens Audiologische Technik GmbH, 91058 Erlangen (DE)
(72) Erfinder: Strohmaier, Harald, W-8520 Erlangen (DE)
(74) Vertreter: Fuchs, Franz-Josef, Dr.-Ing.

(56) Entgegenhaltungen:
- DE-A- 3 505 390
- DE-A- 3 616 773
- DE-U- 8 527 265
- DE-U- 8 527 362
- DE-U- 8 708 894
- DE-U- 8 806 161

## Beschreibung

Die Erfindung betrifft ein am Kopf zu tragendes Hörgerät mit in einem Gehäuse angeordnetem Eingangswandler, Verstärker und Bedienungselementen sowie Stromquelle und Ausgangswandler, wobei wenigstens ein Teil des Verstärkers auf einer wenigstens abschnittsweise verformbaren Leiterplatte angebracht ist und wobei der Eingangs- und der Ausgangswandler elektrisch mit Leiterbahnen der Leiterplatte kontaktiert sind.

Bei einem bekannten Hörgerät dieser Art (DE-A-36 16 773) ist eine im wesentlichen nur Bedienelemente tragende starre Leiterplatte mit einer elektrische Bauteile tragenden flexiblen Leiterplatte mechanisch und elektrisch verbunden, wobei die flexible Leiterplatte zu übereinander oder winkelig zueinander liegenden Leiterplattenebenen gefaltet ist. Die flexible Leiterplatte trägt Leitungsbahnen und ist mehrfach und in verschiedenen Ebenen gefaltet, so daß mehrere Leiterplattenebenen entstehen, die u.a. Anschlüsse für das Mikrofon und Anschlüsse für den Hörer tragen. Die Anordnung und Halterung der relativ großen Hörgerätebauteile, die die Schallwandler bilden, an den flexiblen Leiterplattenebenen führt zu Schwierigkeiten, die einerseits aus der instabilen Halterung selbst und andererseits aus den sich einstellenden Schwingungen resultieren. Eine Anordnung der beiden Schallwandler an der starren Leiterplatte wird wegen der Rückkopplungsgefahr nicht vorgeschlagen.

Bei Kleinhörgeräten ist es bekannt (EP-O 179 257 B1), daß wenigstens ein Teil des Verstärkers auf gelenkig miteinander verbundenen Montageflächen angebracht ist und die gelenkigen Verbindungen eine mit elektrisch leitenden Bahnen versehene flexible Unterlage haben. Dabei ist der Verstärker als Mehrschichtensystem ausgebildet, das wenigstens drei Schichten umfaßt, von denen die zwei äußeren Bauelemente tragen, an einer mit Leiterbahnen versehenen, sogenannten neutralen Zwischenschicht liegen und an mehreren, einander gegenüberliegenden Stellen in Baugruppen unterteilt sind, wobei die mechanische Festigkeit der Zwischenschicht eine Verformung der Anordnung zuläßt. Bei dieser bekannten Verstärkerbauart steht bei einer Vereinfachung des Aufbaues eine große Fläche zur Anbringung der Bauelemente, wie Kondensatoren, Widerstände, integrierte Schaltkreise, Chips, Stellelemente, zur Verfügung. Im Gehäuse des bekannten, hinter dem Ohr zu tragenden (HdO)-Hörgerätes sind ferner zwei gegeneinander abgeschottete Kammern zur Aufnahme der Schallwandler (Mikrofon und Hörer) vorgesehen. Schließlich weist das Gehäuse einen verschließbaren Raum zur Aufnahme einer Batterie als Stromquelle auf. Zum elektrischen Anschluß der beiden Schallwandler an den Verstärkerschaltkreis dienen Litzenverbindungen, die im Gehäuse zu verlegen und an Kontakte der Verstärkerplatine anzulöten sind.

Zur Unterdrükkung von Rückkopplungen zwischen den Wandlern, bzw. zur Störschallunterdrückung (Vermeidung von Rückkopplungen durch Körper- und Luftschall) allgemein, werden die Schallwandler zusätzlich in weiches Dämmaterial, z.B. Gummimaterial mit hohem Dämpfungswert, eingebettet, wie sich aus der CH-A-539 375 ergibt.

Der Erfindung liegt die Aufgabe zugrunde, bei einem am Kopf zu tragenden Hörgerät der eingangs genannten Art die Anordnung der Eingangs- und der Ausgangswandler zu vereinfachen.

Diese Aufgabe wird erfindungsgemäß durch die Merkmale des Patentanspruches 1 gelöst.

Nach der erfindungsgemäßen Lösung können Anschlußlitzen der Schallwandler entfallen, weil die Wandler direkt gegen die Leiterbahnen der Leiterplatte kontaktiert bzw. direkt auf die Leiterplatte gelötet sind. Bei der Anordnung der Schallwandler an der Leiterplatte sind ferner keine gesonderten Schallwandler-Gehäusekammern mehr erforderlich und gesonderte Wandlerlagerungen erübrigen sich. Zudem wird eine erhebliche Montageerleichterung erreicht, da die mit dem Verlegen der bekannten Litzen und den bekannten Litzenführungen verbundenen Probleme entfallen (z.B. keine mechanischen Fixierungen und Klebestellen für die Litzen mehr erforderlich).

Weitere vorteilhafte Ausbildungen der Erfindung sind in den Patentansprüchen 2 bis 4 angegeben.

Danach ist eine Vereinfachung der Abdämmung und Dämpfung der Schallwandler möglich und es ergibt sich ein platzsparender Aufbau, der die angestrebte Verkleinerung der Hörgeräte ermöglicht. Ein weiterer wesentlicher Vorteil der Erfindung besteht darin, daß durch den Wegfall der Gehäuse-Schallwandlerkammern die Gehäuseform und damit das Spritzwerkzeug für das Gehäuse einfacher gestaltet werden kann.

Gemäß der Erfindung können ein oder mehrere Eingangswandler (Mikrofon, Mikrofone) direkt an einer der Verstärkerplatinen der Leiterplatte sitzen, während der Ausgangswandler (Hörer) an der zweiten Verstärkerplatine angeordnet wird. Die Verstärkerplatinen sind über eine elastische Zone verbunden, die Rückkopplungen zwischen den Wandlern weitgehend unterbindet. Über die elastische Zone ist die Leiterplatte biegbar oder faltbar und damit so verformbar, daß die LeiterplattenVerstärker-Schallwandler-Einheit Aufnahme im Hörgerätegehäuse findet. Zur Dämpfung und Halterung dieser Einheit im Gehäuse wird zwischen der Einheit und der Gehäuseinnenwand Dämmaterial vorgesehen. Dieses Dämmaterial kann z.B. in Form einer Auflage zwischen den bestückten Verstärkerplatinen und dem Gehäuse ausgebildet sein. Dabei kann anstelle einer ganzflächigen Umhüllung durch Dämmaterial auch eine abschnittsweise oder punktförmige, dämpfende Abstützung ausreichen.

Weitere Einzelheiten und Vorteile der Erfindung werden nachfolgend anhand der in den Figuren dargestellten Ausführungsbeispiele weiter erläutert.
In der Figur 1 ist in schematischer Darstellung ein aus zwei Schalen bestehendes Gehäuse für ein HdO-Hörgerät im Schnitt dargestellt, wobei lediglich eine erfindungsgemäße Leiterplatten-Verstärker-Schallwandler-Einheit in das Gehäuse eingezeichnet ist, die unter Zwischenlage eines Dämmaterials punkt- oder abschnittsweise gegen die Innenseiten der Gehäuseschalen abgestützt ist,
Figur 2 zeigt eine Draufsicht auf die nicht gefaltete Leiterplatte, deren Verstärkerplatinen mit einem Mikrofon bzw. einem Hörer bestückt sind,
Figur 3 zeigt einen mit der Leiterplatte kontaktierbaren Wandler.

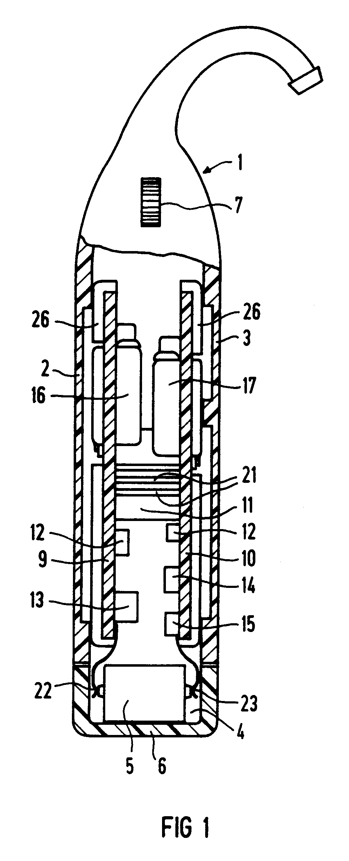

Das in Figur 1 dargestellte Hörgerät 1 weist ein Gehäuse auf, das aus zwei Gehäuseschalen 2, 3 besteht. Im unteren Bereich des Gehäuses befindet sich bei dem als Ausführungsbeispiel schematisch gezeichneten HdO-Gerät ein Raum 4 zur Aufnahme einer Stromquelle/Batterie 5, der über ein ausschwenkbares Gehäuseteil 6 (Batterielade) zugänglich ist. Mit 7 ist als Betätigungselement z.B. ein Lautstärkesteller angedeutet.

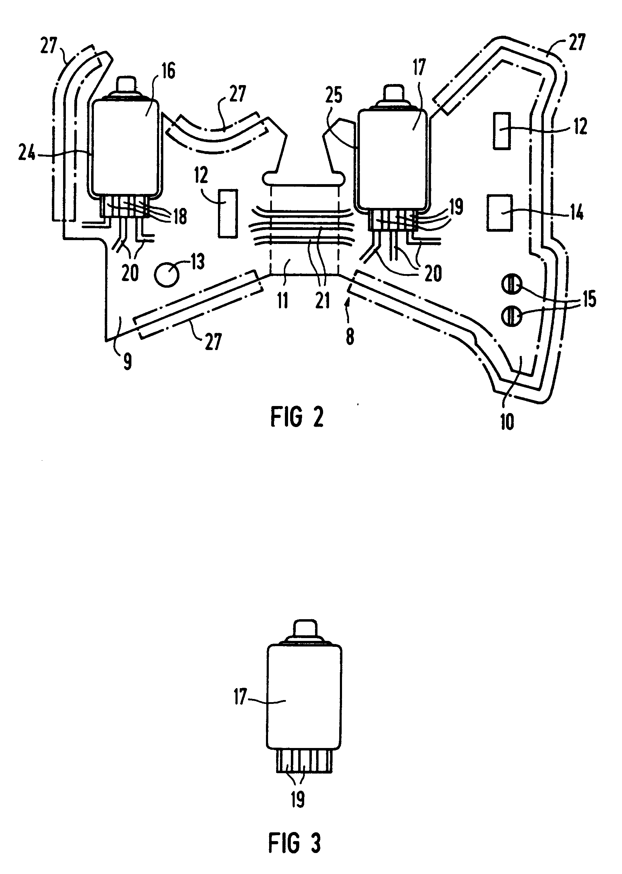

In dem Gehäuse 2, 3 befindet sich ferner eine Verstärkereinheit, bestehend aus einer Leiterplatte 8 aus zwei Verstärkerplatinen 9, 10, die durch eine flexible Zone 11 miteinander verbunden sind. Die Verstärkerplatinen 9, 10 sind in an sich bekannter Weise mit Bauteilen, wie Widerständen 12, Kondensatoren 13, Chips 14, Bedien- oder Stellelementen 15, bestückt. Nach der Erfindung sind ferner direkt auf der Leiterplatte 8 Eingangs- und Ausgangswandler 16 bzw. 17 angebracht. Dabei sitzt der Eingangswandler (Mikrofon) 16 an der einen Verstärkerplatine 9 und der Ausgangswandler (Hörer) 17 an der zweiten Platine 10 und beide Wandler sind mit ihren elektrischen Anschlüssen 18 bzw. 19 direkt gegen Leiterbahnen 20 der Leiterplatte kontaktierbar. Die Leiterbahnen 20 der Verstärkerplatinen 9, 10 sind, wie in Figur 2 durch strichlierte Linien angedeutet ist, durch über die flexible Zone 11 geführte flexible Leiterbahnabschnitte 21 zu einem Verstärkerschaltkreis verbunden. In vorteilhafter Ausführung besteht die flexible Zone 11 der Leiterplatte 8 aus einer biegsamen Folie, die gleichzeitig Rückkopplungen zwischen den Wandlern 16, 17 entgegenwirkt bzw. dämpft. Zur Stromversorgung des Verstärkerstromkreises und der Wandler ist die Leiterplatte 8 über Federkontakte 22, 23 an die Stromquelle 5 anschließbar.

Gemäß Figur 2 weist die Leiterplatte 8 bzw. deren Verstärkerplatine 9, 10 Aussparungen 24 und 25 zur Aufnahme des Eingangs- 16 bzw. Ausgangswandlers 17 auf. Dadurch sind die Wandler besonders platzsparend in die Verstärkerbaueinheit integrierbar, können von den Platinen 9, 10 gehalten werden, während die flexible Zone 11 Kopplungen zwischen den Platinen bzw. den darauf sitzenden Wandlern vermeidet.

Bei Wegfall von Litzenverbindungen sind die Schallwandler 16, 17 mit ihren elektrischen Anschlüssen 18, 19 direkt auf die Verstärkerplatinen 9, 10 auflötbar. In anderer Ausbildung sind jedoch auch Steckverbindungen möglich. Die Leiterplatte kann in der in Figur 2 gezeichneten Form mit den elektrischen Bauelementen 12 bis 15 sowie mit den Wandlern 16, 17 bestückt werden, die Leiterplatten-Verstärker-Wandler-Einheit ist dann als prüfbare Einheit vorgefertigt so über wenigstens eine flexible Zone 11 zusammenlegbar, daß sich die vollständige Halterung der Wandler in der Verstärkereinheit ergibt und daß dann die gesamte Einheit platzsparend in das Hörgerätegehäuse 2, 3 einsetzbar ist.

Zur Dämpfung und Abstützung der Leiterplatten-Verstärker-Wandler-Einheit im Hörgerätegehäuse 2, 3 ist ein dämpfend wirkendes Dämmaterial 26, z.B. ein Gummimaterial oder Kunststoffmaterial mit hohem Dämpfungswert, vorgesehen. Insbesondere soll das Dämmaterial 26 die mit den Wandlern bestückten Verstärkerplatinen weichelastisch im Gehäuse abstützen, wobei die Abstützung ganzflächig, abschnittsweise, linien- oder punktförmig ausgebildet sein kann.

Gemäß Figur 2 ist es möglich, an den Rändern oder an Randabschnitten der Verstärkerplatinen 9, 10 Dämmaterialstreifen 27 anzubringen, die dann die gedämpfte Abstützung der mit den Wandlern bestückten Verstärkereinheit im Gehäuse übernehmen.

In abgewandelter Ausführung können jedoch auch die Gehäuseschalen 2, 3 ganz oder teilweise oder an bestimmten Auflagen mit Dämmaterial ausgekleidet bzw. belegt sein.

In Figur 3 ist ein Wandler, z.B. ein Hörer 17, mit seinen elektrischen Anschlüssen 19 dargestellt, wobei die die Anschlüsse 19 bildende Wandler-Anschlußplatine für eine Steck- und/oder Lötverbindung mit der Leiterplatte 8 ausgelegt ist.

Die Erfindung ist nicht auf HdO-Hörgeräte beschränkt, sondern schließt ebenfalls Kleinhörgeräte, wie In-dem-Ohr- tragbare (IdO)-Hörgeräte, ein.

## Patentansprüche

1. Am Kopf zu tragendes Hörgerät (1) mit in einem Gehäuse (2, 3) angeordnetem Eingangswandler (16), Verstärker und Bedienungselementen sowie Stromquelle (5) und Ausgangswandler (17), wobei wenigstens ein Teil des Verstärkers auf einer wenigstens abschnittsweise verformbaren Leiterplatte (8) angebracht ist und wobei der Eingangs- und der Ausgangswandler elektrisch mit Leiterbahnen (20) der Leiterplatte kontaktiert sind, **gekennzeichnet durch** die Kombination der Merkmale, daß die Leiterplatte (8) aus zwei durch eine flexible Zone (11) verbundenen Verstärkerplatinen (9, 10) besteht, daß auf der einen Verstärkerplatine (9) der Eingangswandler (16) und auf der zweiten Verstärkerplatine (10) der Ausgangswandler (17) direkt angebracht ist, daß die Verstärkerplatinen (9, 10) Aussparungen (24, 25) zur Aufnahme des Eingangs- (16) und Ausgangswandlers (17) aufweisen und daß die mit dem Eingangs- (16) und Ausgangswandler (17) bestückten Verstärkerplatinen der Leiterplatte (8) in einer gefalteten Form eine Einheit bilden, welche in das Hörgerätegehäuse (2, 3) einsetzbar ist.

2. Hörgerät nach Anspruch 1, **dadurch gekennzeichnet**, daß zwischen der Leiterplatte (8) und dem Hörgerätegehäuse (2, 3) ein Dämmmaterial (26) gegen Körperschallübertragung und Störschallunterdrückung, z.B. zur Vermeidung von Rückkopplungen durch Körper- und Luftschall, vorgesehen ist.

3. Hörgerät nach Anspruch 1 und 2, **dadurch gekennzeichnet**, daß die flexible Zone (11) der Leiterplatte (8) eine gegenseitige Beeinflussung der Schallwandler (16, 17) hemmt und daß das Dämmaterial (26) die mit den Wandlern bestückten Verstärkerplatinen (9, 10) weichelastisch gegenüber dem Gehäuse (2, 3) abstützt.

4. Hörgerät nach Anspruch 1 bis 3, **dadurch gekennzeichnet**, daß die Leiterplatte (8) bzw. deren Verstärkerplatinen (9, 10) ganzflächig, abschnittsweise oder punktförmig durch Dämmaterial (26) gegen das Gehäuse (2, 3) abgestützt ist bzw. sind.

## Claims

1. Hearing aid (1) to be worn on the head, having an input transducer (16) arranged in a housing (2, 3), amplifier and operating means as well as a current source (5) and output transducer (17), with at least a part of the amplifier being fitted to a printed circuit board (8) which can be shaped at least in sections and with the input transducer and the output transducer being electrically contacted with printed conductors (20) of the printed circuit board, characterized by the combination of the features that the printed circuit board (8) consists of two amplifier boards (9, 10) connected by a flexible zone (11), that the input transducer (16) is directly applied to the one amplifier board (9) and the output transducer (17) is directly applied to the second amplifier board (10), that the amplifier boards (9, 10) have recesses (24, 25) for the accommodation of the input transducer (16) and output transducer (17) and that the amplifier boards of the printed circuit board (8) fitted with the input transducer (16) and output transducer (17) form in a folded form a unit which can be inserted into the hearing-aid housing (2, 3).

2. Hearing aid according to claim 1, characterized in that an insulating material (26) against the transmission of structure-borne noise and noise suppression, for example to avoid feedback through structure-borne noise and air-borne noise, is provided between the printed circuit board (8) and the hearing-aid housing (2, 3).

3. Hearing aid according to claims 1 and 2, characterized in that the flexible zone (11) of the printed circuit board (8) impedes a mutual influencing of the sound transducers (16, 17) and in that the insulating material (26) supports the amplifier boards (9, 10) fitted with the transducers in a flexible manner against the housing (2, 3).

4. Hearing aid according to claims 1 to 3, characterized in that the printed circuit board (8) or its amplifier boards (9, 10) is or are supported against the housing (2, 3) by insulating material (26) over the entire area, in sections or in punctiform manner.

## Revendications

1. Appareil de correction auditive (1) destiné à être porté sur la tête et comportant un transducteur d'entrée (16) disposé dans un boîtier (2,3), un amplificateur et des éléments de commande ainsi qu'une source de courant (5) et un transducteur de sortie (17), et une partie de l'amplificateur étant disposée sur une plaquette à circuits imprimés (8) qui peut se déformer au moins par endroits, et le transducteur d'entrée et le transducteur de sortie étant raccordés électriquement à des voies conductrices (20) de la plaquette à circuits imprimés, caractérisé par la combinaison des caractéristiques consistant en ce que la plaquette à circuits imprimés (8) est constituée de deux platines (9,10) d'amplificateurs, qui sont reliées par une partie flexible (11), que le transducteur d'entrée (16) est disposé directement sur l'une (9) des platines d'amplificateur et que le transducteur de sortie (17) est disposé directement sur la seconde platine d'amplificateur (10), que les platines d'amplificateurs (9,10) comportent des évidements (24,25) servant à loger le transducteur d'entrée (16) et le transducteur de sortie (17), et que les platines d'amplificateurs de la plaquette à circuits imprimés (8), qui sont munies du transducteur d'entrée (16) et du transducteur de sortie (17), forment, dans un état replié, une unité qui peut être insérée dans le boîtier (2,3) de l'appareil de correction auditive.

2. Appareil de correction auditive suivant la revendication 1, caractérisé par le fait qu'entre la plaquette à circuits imprimés (8) et le boîtier (2,3) de l'appareil de correction auditive est prévu un matériau d'isolation (26) s'opposant à la transmission du bruit de structure et supprimant les bruits parasites, par exemple pour empêcher des couplages en retour dûs au son transmis par la structure et au son transmis dans l'air.

3. Appareil de correction auditive suivant la revendication 1 ou 2, caractérisé par le fait que la partie flexible (11) de la plaquette à circuits imprimés (8) empêche une influence mutuelle des transducteurs acoustiques (16,17) et le matériau d'isolation (26) supporte avec une élasticité molle par rapport au boîtier (2,3) les platines d'amplificateurs (9,10) munies des transducteurs.

4. Appareil de correction auditive suivant l'une des revendications 1 à 3, caractérisé par le fait que la plaquette à circuits imprimés (8) ou ses platines d'amplificateurs (9,10) s'appuie(nt) par le matériau d'isolation (26), sur toute la surface, par endroits ou d'une manière ponctuelle, sur le boîtier (2,3).
